# EUROPEAN PATENT SPECIFICATION

(11) **EP 0 629 716 B1**
(45) Date of publication and mention of the grant of the patent: **11.09.2002**
(21) Application number: 94303718.4
(22) Date of filing: 24.05.1994
(51) Int. Cl.: C23C 16/44, C23C 14/50

(54) **Susceptor for vapor deposition**
Substrathalter für die Abscheidung aus der Dampfphase
Suscepteur pour le dépôt en phase vapeur

(30) Priority: 29.10.1993 US 146370; 27.05.1993 JP 12610093
(43) Date of publication of application: 21.12.1994
(73) Proprietor: APPLIED MATERIALS, INC., Santa Clara, California 95054-3299 (US)
(72) Inventor: Aruga, Michio, Inba-gun, Chiba-ken 286-02 (JP); Ohkura, Atsunobu, Chiba-ken 289-11 (JP); Saito, Akihiko, Chiba-shi, Chiba-ken 262 (JP); Anan, Katsumasa, Narita-shu, Chiba-ken 286 (JP)
(74) Representative: Bayliss, Geoffrey Cyril

(56) References cited:
- EP-A- 0 506 391
- EP-A- 0 595 054

## Description

This invention relates to susceptors for use in chemical vapour deposition (CVD) devices and, more particularly, to susceptors made of a ceramic material for use in plasma enhanced chemical vapour deposition devices.

Chemical vapour deposition device have been used for some time in the deposition of thin films on semiconductor substrates. In such devices, a gas containing the structural elements of the film material to be formed is first fed into a chamber, followed by heating the gas to induce a chemical reaction to deposit the desired film on a semiconductor substrate.

In a typical single-wafer CVD device, the platform that is used to hold the semiconductor substrate in place for the deposition process is called a susceptor. The susceptor is usually constructed of a thin plate for low mass and a surrounding rim for rigidity. At this time, the diameter of a susceptor in a typical reaction vessel is approximately 9" (228mm) while the diameters of wafers being coated are normally 6" or 8" (152 or 203mm). The susceptor can be made of graphite or aluminium coated with a silicon carbide coating so that it can be heated to the deposition temperature of the thin film without significant distortion. Still others have proposed methods of treating metal surfaces to improve their durability at high temperatures. For instance, U.S.-A-5,201,990 discloses a process for treating aluminium surfaces in a vacuum apparatus with a plasma consisting of a nitrogen-containing gas of either nitrogen or ammonia.

To select a suitable material for the susceptor used in a CVD device, the following criteria must be met. First, the thermal conductivity of the material must be sufficiently high such that any distortion in its dimensions and any deterioration in the material at the high operating temperatures of the CVD device is minimised. Secondly, when in situ plasma chamber cleaning methods are utilised, the material used for the susceptor must be resistant to any corrosive effect of the plasma. Thirdly, the susceptor material must be of high purity in order to preclude contamination of the semiconductor substrate impurities contained in the material.

As a consequence, metallic materials that are electrically conductive and that have high thermal conductivity are conventionally used for the susceptor. In particular, certain metal alloys of nickel such as Monel™, Hastelloy™, etc., are frequently used for their resistance to fluorine-containing plasma which is one of the highly reactive plasmas often used in in-situ plasma chamber cleaning steps. Ceramic materials such as silicon carbide and graphite have also been used. In devices where the susceptor plate has to act as a high-frequency electrode, a conductive material such as metal must be used.

When conventional materials such as Monel™, Hastelloy™, silicon carbide and graphite are used as the susceptor material, a protective coating layer is normally required to cover the surface of the susceptor and to protect it from the corrosive effect of the plasma.

When metallic materials are used in the susceptor, plastic deformations in the material occur in response to sudden changes in temperature. This leads to the problem of the protective film peeling off due to the difference in the values of coefficient of thermal expansion between the protective film and the metal material.

When ceramic materials are used in the susceptor, even though plastic deformation does not occur, the protective film still peels off the surface of the susceptor after a certain number of plasma cleaning processes. This may be because even small differences in the values of coefficients of thermal expansion between the protective film and the ceramic materials eventually have an effect after a number of process cycles. The protective layer itself may still be gradually eroded after many cleaning operations by the highly reactive plasmas and gases employed in such cleaning operations.

A susceptor made of such conventional materials therefore has problems in achieving both long term durability and reliability.

EP-A-0506391 discloses a thermal CVD chamber in which a disk-shaped ceramic heater for heating wafers is mounted in a casing in the interior of the chamber. The heater consists of a substrate made of a dense and gas-tight aluminium nitride having a tungsten series heat-generating resistive body spirally embedded in the disk.

EP-A-059504 discloses a method for processing a semiconductor wafer in a reactor at a wafer support temperature in excess of 400ºC and preferably at least about 500ºC or higher without warpage while providing corrosion resistance to the chemicals used in the reactor during such processing. In the process the semiconductor wafer is supported on a wafer support or susceptor comprising graphite materials coated with a protective coating of aluminium nitride.

It is an object of the present invention to provide a susceptor plate that does not require a protective coating when the susceptor plate is used in a CVD chamber.

This invention provides a deposition chamber including an aluminium nitride disc-shaped susceptor plate having a top surface, a bottom surface and a predetermined diameter for supporting a substrate, an electrode plate having a predetermined outside diameter less than that of the susceptor juxtaposed to the bottom surface of said susceptor plate, and an electrode cover having an external diameter larger than the outside diameter of the electrode plate, the cover being demountably attached to the bottom surface of said susceptor plate and around the outer periphery of the electrode plate and providing a cavity adapted to receive and shield said electrode plate; where the electrode plate is ring shaped; and in that the electrode cover is disc shaped and extends inwardly of the periphery of the susceptor plate over the bottom surface of the plate and has a central hollow section to accommodate the ring shaped electrode plate.

As a consequence of using aluminum nitride which has superior fluorine plasma resistance as the material for the susceptor plate, no corrosion or deformation of the susceptor plate is observed, nor are particulates formed, even when the plate is used at high temperatures within rigorous reactive plasma environments, particularly in cleaning operations. The superior thermal conductivity of aluminum nitride also improves the uniformity of temperature over the surface of the susceptor which presents another processing advantage.

The susceptor assembly with the electrode plate being attached to the bottom surface of the susceptor plate provides a high-frequency electrode, the electrode plate being covered by the electrode cover which is made of a ceramic material ans is demountably attached to the susceptor plate such that any adverse effect of the fluorine plasma is avoided.

Other objects, features and advantages of the present invention will become apparent upon consideration of the specification and the appended drawings, in which:
Figure 1 is a perspective view of a susceptor assembly according to the present invention.
Figure 2 is a partially sectioned and enlarged perspective view of a susceptor assembly according to the present invention.
Figure 3 is an enlarged cross-sectional view of the susceptor assembly.
Figure 4 is a cross-sectional view of CVD device which has a sesceptor assembly installed therein.

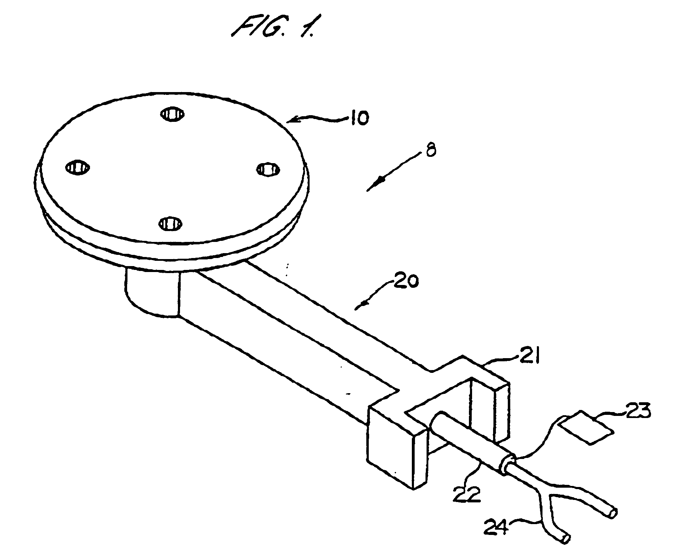

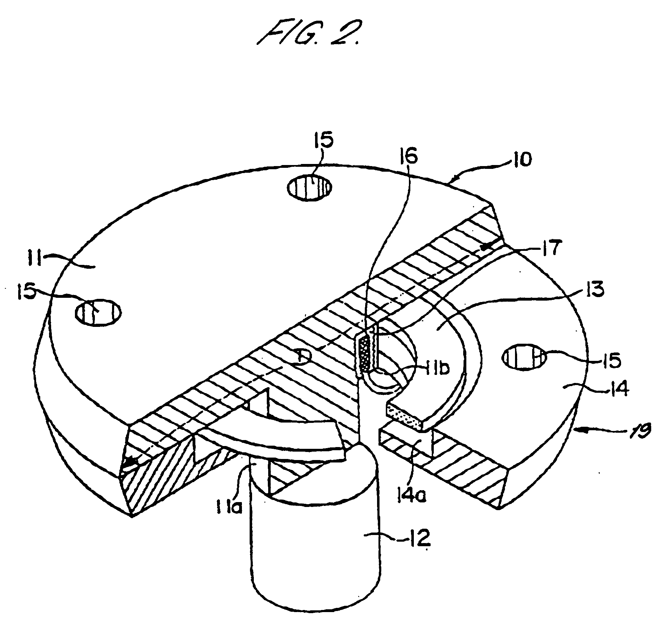

Referring initially to Figure 1, a susceptor device 8 according to the present invention is shown having a susceptor assembly 10 and a susceptor support arm 20. As shown in Figure 2, the susceptor assembly 10 consists of a susceptor plate 11, a metallic electrode plate 13 affixed to the back surface of the susceptor plate 11. An electrode cover 19 is mounted to the back surface of susceptor plate 11 to cover the metallic electrode plate 13. Figure 2 shows that susceptor plate 11 is a disc-shaped plate having a predetermined outer diameter D and a cylindrical hub 11a at the centre. The susceptor plate 11 is made of aluminium nitride material. Aluminium nitride has been used as a semiconductor material in recent years primarily for its high thermal conductivity. It was only through the unique discover of the present invention that aluminium nitride was found to have superior fluorine-plasma resistance.

In the manufacturing of aluminium nitride parts, it is customary to add yttrium or erbium into the mix as a mold release agent. However, it is believed that yttrium may have some adverse effect on the wafer properties. High purity aluminium nitride with a minimum amount of impurities such as yttrium is therefore preferred.

As shown in Figure 2, a high-frequency RF contact post 12 is affixed to the hub 11a of the susceptor plate 11. The metallic electrode plate 13 is a ring-shaped member. The electrode cover 19 is a disc-shaped member having a center hollowed-out section 14a on surface 14 facing the susceptor plate 10 adapted to accept the electrode plate 13. Alumina is frequently the material used for the electrode cover 19.

Holes 15 are provided and aligned in the electrode cover 19 and the susceptor plate 11. A number of rods (not shown) are positioned in holes 15 for elevating and lowering a wafer situated on susceptor plate 11 during processing.

Figure 2 also shows a thermocouple mounting post 11b which is attached to hub 11a adapted to accept a thermocouple 16. Thermocouple 16 is fixed to mounting post 11b by metallic member 17 in the following manner. First, a tapped hole (not shown) is provided for mounting post 11b by perforating the susceptor plate 11. A threaded hollow cylindrical metallic member 17 is then provided to engage with the tapped hole. In the hollow part of the metallic member 17, a second tapped hole (not shown) is drilled. A threaded thermocouple 16 is then engaged in the second tapped hole. The metallic member 17 is preferably made of nickel which has a superior thermal conductivity.

It should be noted that thermocouple 16 is preferably not inserted directly into susceptor plate 11, but instead is inserted into the metallic member 17 in order to avoid any potential cracking problems of the ceramic susceptor plate 11. This provides a significant processing advantage when thermocouple 16 is repeatedly inserted into and removed from the susceptor plate 11 when service or exchange of the thermocouple 16 is necessary.

The RF contact post 12 and the metallic electrode plate 13 are connected by wiring which is not shown in Figure 2. As shown in Figure 1, the distant end of the susceptor support arm 20 has a cylindrical shape with a bottom surface and attached on the near end is a U-shaped connector 21 for mounting to a CVD body. Insulator tube 22 passes through the interior of the susceptor support arm 20 while lead 23 for thermocouple 16 and lead 24 for RF electrode plate 13 pass through the inside of tube 22.

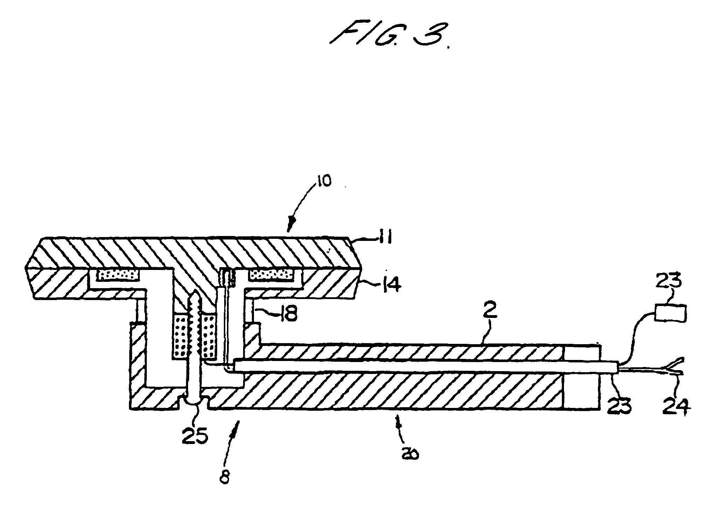

The susceptor assembly 10 and the susceptor support arm 20 are connected together by bolt 25 as shown in Figure 3. Collar 18 is provided at the junction of 10 and 20 to enable an air tightness inside the susceptor assembly.

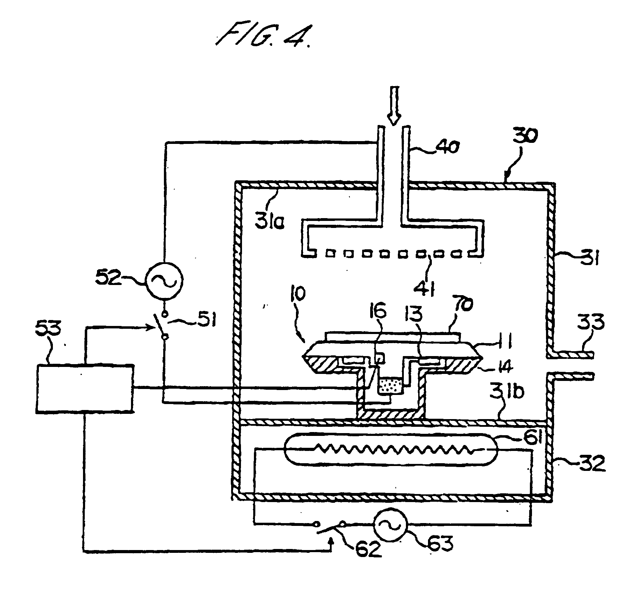

Figure 4 shows a susceptor assembly 10 mounted in a CVD device. Reaction chamber 30 consists of a main compartment 31 and a heat lamp compartment 32. Susceptor assembly 10 is mounted on floor 31b of reaction chamber 31. A reaction gas inlet 40 is mounted on top 31a of reaction chamber 31. The gas spray port 41 of the reaction gas inlet 40 and the susceptor plate 11 of the susceptor assembly 10 are positioned facing each other. The reaction gas inlet 40 also serves as the RF electrode and is in a paired relationship with the metallic electrode plate 13 in the susceptor assembly 10. The RF electrode 40 and metallic electrode plate 13 are connected to a high-frequency power source 52 through a control switch 51. The thermocouple 16 positioned in the susceptor assembly 10 is connected to controller 53 such that the output signals from thermocouple 16 are fed into controller 53. A gas exhaust port 33 is provided in the sidewall of reaction chamber 31.

As shown in Figure 4, a heat lamp 61 is positioned in the heat lamp compartment 32. It is connected to an alternating-current power source 63 through a control switch 62. A floor 31b is provided between the main compartment 31 and the heat lamp compartment 32 for mounting of the susceptor assembly 10. It is positioned such that heat emitted from heat lamp 61 radiates to susceptor plate 11. To facilitate the heat radiation, sections of quartz glass are inserted into the metallic plate which composes floor 31b.

Controller 53 controls the output of heat lamp 61 by the data feedback from thermocouple 16 and the control of the alternating-current power source 63.

The susceptor plate 11 is made of aluminum nitride. Since aluminum nitride and aluminum have the same thermal conductivity, the temperature uniformity achieved on the surface of an aluminum nitride susceptor plate is nearly the same as that achieved on the surface of an aluminum susceptor plate.

The following is a process description for forming a SiO₂ film on a semiconductor substrate using the present invention.

As seen in Figure 4, to begin the process, switch 62 of heat lamp 61 is first turned on. The temperature of the susceptor plate 11 is increased to over 500°C by the radiant heat from heat lamp 61. A semiconductor substrate 70 is then placed on the susceptor plate 11. TEOS (tetra-ethoxy-ortho-silicate) which is the primary reaction gas for SiO₂ is introduced through the reaction gas inlet 40 into reaction chamber 30. A mixture of TEOS and an oxidizer is sprayed onto the semiconductor substrate 70. During the flow of the reaction gas, semiconductor substrate 70 is heated for a predetermined period of time. A SiO₂ film is thus formed on the semiconductor substrate 70.

The same susceptor assembly can be used to form refractory metal films such as tungsten, etc. using appropriate reactive gases.

It is necessary to periodically clean the interior of the reaction chamber 30 since SiO₂ is deposited non-discriminatorily on all surfaces inside the reaction chamber 30. A method of cleaning will now be illustrated.

To start the cleaning process, a fluorine-containing gas is first introduced through the reaction gas inlet 40 into the reaction chamber 30. Along with the introduction of the fluorine-containing gas, control switch 51 is turned on and a voltage is applied to the reaction gas inlet 40 and the metallic electrode plate 13 positioned in the susceptor assembly 10. This ignites a fluorine-containing plasma inside the reaction chamber 30. The plasma etches the SiO₂ film and cleans it off the interior surfaces of reaction chamber 30.

When the susceptor plate made of aluminum nitride of the present invention is used, the superior resistance of aluminum nitride to fluorine plasma prevents any generation of particulates from or corrosion of the susceptor plate even after prolonged period of use. There is no abrasion of the susceptor plate and therefore it is not necessary to cover the surface with a protective coating. The present invention therefore provides a novel susceptor plate that has superior reliability and durability.

Another benefit made possible by the present invention is that the metallic electrode plate 13 which is mounted to the bottom surface of the susceptor plate 11 is protected by a ceramic electrode cover mounted to the susceptor plate 11. The metallic electrode plate 13 is shielded from the plasma and consequently, is shielded from attack by the plasma.

Furthermore, the CVD chamber illustrated above can also be used in a plasma enhanced CVD process. A plasma enhanced CVD process can be carried out by using the reaction gas inlet 40 as a plasma electrode and the metallic electrode plate 13 as the other plasma electrode. The susceptor assembly illustrated in the present invention can also be used in other CVD devices that do not use lamp heating, for instance, it can be used in devices that utilize induction heating.

The present invention provides a durable and reliable CVD device by utilizing a susceptor plate made of aluminum nitride material. By using aluminum nitride, there is no generation of particulates from or corrosion of the susceptor plate. Moreover, there is no abrasion on the susceptor plate after prolonged usage and thus no need to cover the surface of the susceptor plate with a protective film.

It will be appreciated by those skilled in the art that many variations may be made to the above described embodiment without departing from the scope of the invention as defined in the following claims.

## Claims

1. A deposition chamber including an aluminum nitride disc-shaped susceptor plate (11) having a top surface, a bottom surface and a predetermined diameter (D) for supporting a substrate, an electrode plate (13) having a predetermined outside diameter less than that of the susceptor juxtaposed to the bottom surface of said susceptor plate, and an electrode cover (19) having an external diameter larger than the outside diameter of the electrode plate (13), the cover being demountably attached to the bottom surface of said susceptor plate and around the outer periphery of the electrode plate and providing a cavity (14a) adapted to receive and shield said electrode plate; **characterised in that** the electrode plate is ring shaped; and **in that** the electrode cover is disc shaped and extends inwardly of the periphery of the susceptor plate over the bottom surface of the plate and has a central hollow section to accommodate the ring shaped electrode plate.

2. A deposition chamber as claimed in claim 1, which further includes gas injectors (40) for introducing a cleaning gas or a process gas into the chamber (31).

3. A deposition chamber as claimed in claim 2, **characterised in that** the said electrode plate (13) is adapted to be energized by a voltage suitable for ionizing said gas to establish a plasma within the deposition chamber.

4. A deposition chamber as claimed in claim 1, **characterised in that** the said electrode cover (19) is made of a ceramic material.

5. A deposition chamber as claimed in claim 1, **characterised in that** the said external diameter of said electrode cover (19) is the same as the diameter of the susceptor plate (11).

6. A deposition chamber as claimed in claim 1, **characterised in that** the said deposition chamber (31) is a chemical vapor deposition chamber or a plasma enhanced chemical vapor deposition chamber.

## Patentansprüche

1. Abscheidungskammer mit einer scheibenförmigen Aluminlumnitrid-Suszeptorplatte (11), welche eine obere Fläche, eine untere Fläche und einen vorher festgelegten Durchmesser (D) zum Halten eines Substrats hat, mit einer Elektrodenplatte (13), die einen vorher festgelegten Außenseitendurchmesser hat, der kleiner ist als des der neben der unteren Fläche der Suszeptorplatte angeordneten Suszeptors, und mit einer Elektrodenabdeckung (19), die einen äußeren Durchmesser hat, der größer ist als der Außenseitendurchmesser der Elektrodenplatte (13), wobei die Abdeckung abnehmbar an der unteren Fläche der Suszeptorplatte und um den äußeren Umfang der Elektrodenplatte herum befestigt ist und einen Hohlraum (14a) bildet, der für die Aufnahme und Abschirmung der Elektrodenplatte angepasst ist, **dadurch gekennzeichnet, dass** die Elektrodenplatte ringförmig ist und dass die Elektrodenabdeckung scheibenförmig ist und sich innerhalb des Umfangs der Suszeptorplatte über der unteren Fläche der Platte erstreckt und einen zentralen hohlen Abschnitt für die Aufnahme der ringförmigen Elektrodenplatte hat.

2. Abscheidungskammer nach Anspruch 1, welche weiterhin Gasinjektoren (40) zum Einführen eines Reinigungsgases oder eines Prozessgases in die Kammer (31) aufweist.

3. Abscheidungskammer nach Anspruch 2, **dadurch gekennzeichnet, dass** die Elektrodenplatte (13) für eine Erregung durch eine Spannung angepasst ist, die zum lonisieren des Gases geeignet ist, um ein Plasma in der Abscheidungskammer zu erzeugen.

4. Abscheidungskammer nach Anspruch 1, **dadurch gekennzeichnet, dass** die Elektrodenabdeckung (19) aus einem keramischen Material hergestellt ist.

5. Abscheidungskammer nach Anspruch 1, **dadurch gekennzeichnet, dass** der äußere Durchmesser der Elektrodenabdeckung (19) genau so groß ist wie der Durchmesser der Suszeptorplatte (11).

6. Abscheidungskammer nach Anspruch 1, **dadurch gekennzeichnet, dass** die Abscheidungskammer (31) eine chemische Gasphasenabscheidekammer oder eine plasmaverstärkte chemische Gasphasenabscheidungskammer ist.

## Revendications

1. Chambre de dépôt comprenant une plaque (11) de suscepteur en forme de disque en nitrure d'aluminium ayant une surface supérieure, une surface inférieure et un diamètre prédéterminé (D) pour supporter un substrat, une plaque d'électrode (13) ayant un diamètre extérieur prédéterminé inférieur à celui du suscepteur, juxtaposé à la surface inférieure de ladite plaque de suscepteur, et un capot (19) d'électrode ayant un diamètre extérieur plus grand que le diamètre extérieur de la plaque d'électrode (13), le capot étant relié de façon démontable à la surface inférieure de ladite plaque de suscepteur et autour de la périphérie extérieure de la plaque d'électrode et présentant une cavité (14a) conçue pour recevoir et protéger ladite plaque d'électrode; **caractérisée en ce que** la plaque d'électrode est en forme d'anneau; et **en ce que** le capot d'électrode est en forme de disque et s'étend vers l'intérieur de la périphérie de la plaque de suscepteur au-dessus de la surface inférieure de la plaque et présente une section centrale creuse pour loger là plaque d'électrode en forme d'anneau.

2. Chambre de dépôt selon la revendication 1, qui comprend en outre des injecteurs (40) de gaz destinés à introduire un gaz de nettoyage ou un gaz de traitement dans la chambre (31).

3. Chambre de dépôt selon la revendication 2, **caractérisée en ce que** ladite plaque d'électrode (13) est conçue pour être alimentée en énergie par une tension apte à ioniser ledit gaz afin d'établir un plasma à l'intérieur de la chambre de dépôt.

4. chambre de dépôt selon la revendication 1, **caractérisée en ce que** ledit capot (19) d'électrode est formé d'une matière céramique.

5. Chambre de dépôt selon la revendication 1, **caractérisée en ce que** ledit diamètre extérieur dudit capot (19) d'électrode est égal au diamètre de la plaqué (11) de suscepteur.

6. Chambre de dépôt selon la revendication 1, **caractérisée en ce que** ladite chambre de dépôt (31) est une chambre de dépôt chimique en phase vapeur ou une chambre de dépôt chimique en phase vapeur activé par plasma.
